# EUROPÄISCHE PATENTANMELDUNG

(11) **EP 0 852 451 A2**
(43) Veröffentlichungstag der Anmeldung: **08.07.1998**
(21) Anmeldenummer: 97122414.2
(22) Anmeldetag: 18.12.1997
(51) Int. Cl.: H04R 25/00

(54) **Hörhilfegerät**

(30) Priorität: 02.01.1997 DE 19700052
(71) Anmelder: Siemens Audiologische Technik GmbH, 91058 Erlangen (DE)
(72) Erfinder: Ach-Kowalewski, Gerhard, 91090 Effeltrich (DE); Husung, Kunibert, Dipl Ing.(TH), 91052 Erlangen (DE); Knapp, Benno, Dipl. Ing. (FH), 91056 Erlangen (DE)
(74) Vertreter: Epping, Wilhelm, Dr.-Ing.

(57) **Zusammenfassung**

Zur Verbesserung der EMV-Festigkeit der Schaltungsanordnung des Hörhilfegerätes ist vorgesehen, daß die Oberfläche der Multilayer-Leiterplatte (10) zur elektromagnetischen Abschirmung der Schaltungsanordnung bis auf Kontaktanschlüsse (15, 15', 15'', 15''') oder Kontakt- und Leiterflächen zur Kontaktierung elektrischer Bauelemente (17, 18) mit einer ein Potential bildenden Masse (11) überzogen ist.

## Beschreibung

Die Erfindung betrifft ein Hörhilfegerät, mit einer im Gehäuse angeordneten Schaltungsanordnung mit flexibel ausgebildeter Multilayer-Leiterplatte.

Elektrische Schaltungen in der Anordnung als mehrlagiges Multisubstrat (Multilayer) mit einer Bestückungsebene, einer Zwischenebene und einer Unterebene sind beispielsweise aus der EP 0 183 936 A1 bekannt.

Aufgabe der Erfindung ist es, die elektromagnetische Verträglichkeit (EMV) der Schaltungsanordnung bei Hörhilfegeräten gegen elektromagnetische Störstrahlung zu verbessern.

Diese Aufgabe wird bei einem Hörhilfegerät der eingangs genannten Art durch die Merkmale des Patentanspruches 1 gelöst. Dabei ist es vorteilhaft, wenn die Oberfläche der Leiterplatte zur elektomagnetischen Abschirmung der Schaltungsanordnung bis auf Kontaktanschlüsse oder Kontakt- und Leiterflächen zur Kontaktierung elektrischer Bauelemente mit einer ein Potential bildenden Masse überzogen ist. Aufgrund der vorgesehenen Abschirmung der Schaltungsanordnung der Multilayer-Leiterplatte und durch die Ableitung von störenden HF-Strömen über eine Masseerdung kann die EMV-Festigkeit der Schaltungsanordnung der Multilayer-Leiterplatte wesentlich erhöht werden.

Da bei Multilayer-Platinen die elektrischen Bauelemente der Schaltungsanordnung nur auf den beiden Außenseiten (Bestückungsebenen) aufgebracht werden können, ist es von Vorteil, wenn die Bestückungsebene bzw. Bestückungsebenen der Multilayer-Leiterplatte bis auf ihre Kontaktanschlüsse oder Kontakt- und Leiterflächen zur Kontaktierung elektrischer Bauelemente mit einer ein Potential bildenden Masse belegt ist bzw. sind.

Vorteilhafte Ausgestaltungen der Erfindung sind in den Patentansprüchen 2 und 3 angegeben.

Elektrische Hörhilfegeräte sind mit einem Gehäuse versehen, in dem eine Verstärkerschaltung angeordnet ist, die wenigstens ein Mikrofon sowie Schalt- und/oder Anschlußmittel und eine spannungsguelle umfaßt, wobei der Verstärkerschaltung ferner wenigstens ein Hörer zugeordnet ist. Die Signalverarbeitungsschaltung solcher Hörhilfegeräte ist gegen hochfrequente elektromagnetische Wellen bzw. gegen Elektrosmog zu schützen. Erfindungsgemäß wird deshalb zur Ausbildung der Schaltungsanordnung bei Hörhilfegeräten eine Multilayer-Leiterplatte der oben beschriebenen Art vorgesehen, wobei das Massepotential der Leiterplatte eine Abschirmung der Schaltungsanordnung des Hörhilfegerätes gegen hochfrequente elektromagnetische Störstrahlung bildet.

Weitere Merkmale der Erfindung ergeben sich aus der folgenden Zeichnungsbeschreibung. Es zeigen:
- Fig. 1: eine in größerem Maßstab und im Schnitt dargestellte Multilayer-Leiterplatte gemäß dem Stand der Technik, und
- Fig. 2: ein schematisch dargestelltes Ausführungsbeispiel einer Multilayer-Leiterplatte eines Hörhilfegerätes nach der Erfindung.

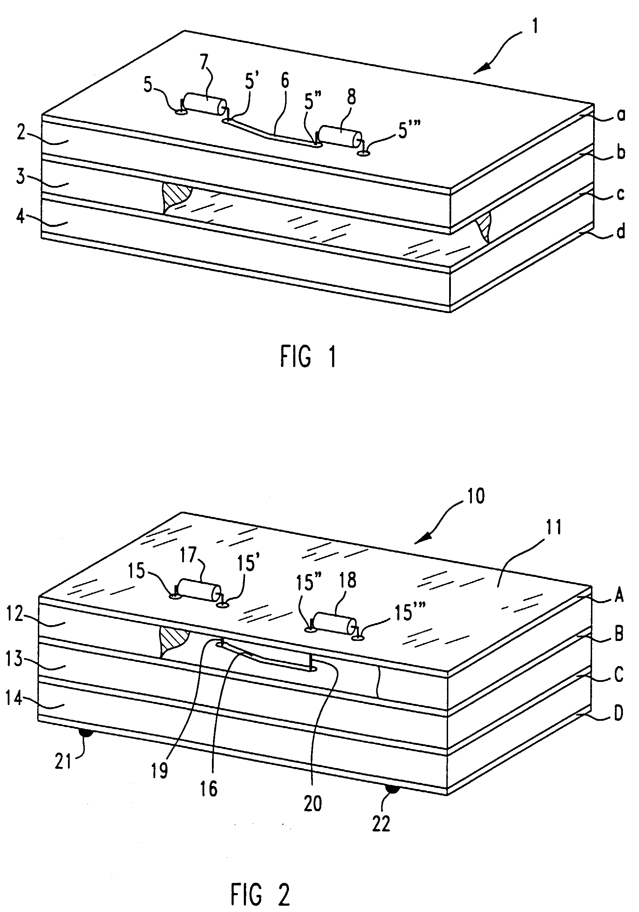

In Fig. 1 ist im Schnitt eine Multilayer-Leiterplatte 1 gezeichnet, die aus Trägerschichten 2, 3, 4 besteht und wobei ein im Inneren der Platine liegender Layer c als Masselage c vorgesehen ist, der einen gewissen EMV-Schutz für die bekannte Schaltungsanordnung bilden soll. In vereinfachter Darstellung sind auf der Bestückungsebene a (Layer a) der bekannten Platine 1 elektrische Bauelemente 7, 8 mit ihren elektrischen Anschlüssen gegen Kontaktanschlüsse 5, 5', 5'', 5''' der Platine kontaktiert. Mit 6 ist eine Leiterbahn zwischen den Kontaktanschlüssen 5', 5'' angedeutet. Da bei den Multilayer-Platinen die elektrischen Bauteile nur auf den beiden Außenseiten aufgebracht werden können und sich wegen der Vielzahl von elektrischen Verbindungen zwischen den Bauteilen keine größeren Zusammenhängenden Flächen ergeben, die mit Massepotential gefüllt werden könnten, ist bei der bekannten Platine 1 die zur Abschirmung dienende Masselage c im Inneren der Platine angeordnet. Diese Anordnung wirkt sich negativ auf die Abschirmungswirkung aus.

Bei der bekannten Platine 1 sind beispielsweise die Bestückungsebene und die Unterebene d (Layer d) aus Metallschichten, z.B. Kupferschichten, gebildet und mit Bauteilen bestückbar. Die neben der Masselage c (Layer c) noch vorgesehene Zwischenebene b (Layer b) kann ebenfalls noch eine Metallschicht oder eine Isolierschicht (Prepreg) bilden.

Die in Fig. 2 in einem schematisierten Ausführungsbeispiel dargestellte Multilayer-Leiterplatte 10 für ein erfindungsgemäßes Hörhilfegerät umfaßt eine Bestückungsebene A (Layer A), eine erste Zwischenebene B (Layer B), eine zweite Zwischenebene C (Layer C) und eine Unterebene D (Layer D), wobei auch diese Unterebene noch eine Bestückungsebene bilden kann. Zur Verbesserung des EMV-Schutzes dieser Multilayer-Leiterplatte 10 sind deren Bestückungsebenen, im Beispiel Layer A, mit einem Massepotential 11 belegt. Sollte es nicht möglich sein, sowohl die Oberseite als auch die Unterseite der Platine mit Masse zu belegen, weil die Anzahl der dazwischenliegenden Layers begrenzt ist und nicht mehr zur Realisierung der Bauteilverbindungen ausreicht, sollte zumindest die Oberseite mit Massepotential 11 belegt sein.

Nach der Erfindung ist vorgesehen, daß die Oberfläche der Leiterplatte 10 zur elektromagnetischen Abschirmung der Schaltungsanordnung bis auf Kontaktanschlüsse 15, 15', 15'', 15''' der elektrischen Bauelemente 17, 18 mit Masse 11 belegt ist. Im Ausführungsbeispiel umfaßt die Platine 10 die Trägerschichten 12, 13 und 14. Bei der gezeichneten Ausführung sind die eingezeichneten elektrischen Verbindungen 16, 19, 20 der elektrischen Bauelemente 17, 18 auf die unter der Bestückungsebene (Layer a) liegende erste Zwischenebene B (Layer B) verlegt.

Zur räumlichen Anpassung im Hörgerätegehäuse ist die Multilayer-Leiterplatte 10 flexibel ausgebildet. Da die Platine 10 vor dem Einbau in ein Hörgerätegehäuse gefaltet wird, ist für die Abschirmung der Platine insbesondere deren Oberseite interessant. In weiterer Ausgestaltung der Erfindung können an der Unterseite der Leiterplatten-Unterebene (Layer D) noch Testanschlüsse 21, 22 vorgesehen sein.

## Patentansprüche

1. Hörhilfegerät, mit einer im Gehäuse angeordneten Schaltungsanordnung mit flexibel ausgebildeter Multilayer-Leiterplatte,
- wobei die Leiterplatte aus wenigstens einer Trägerschicht (12, 13, 14) mit wenigstens einer Bestückungsebene (Layer A) und einer Unterebene (Layer D) besteht,
- wobei zumindest die Oberseite der Leiterplatte (10) zur Abschirmung der Schaltungsanordnung gegen hochfrequente elektromagnetische Störstrahlung bis auf Kontaktanschlüsse (15, 15', 15'', 15''') oder Kontakt- und Leiterflächen zur Kontaktierung elektrischer Bauelemente (17, 18) mit Massepotential (11) belegt ist und
- wobei elektrische Verbindungen oder Leiterbahnen (16, 19, 20) der elektrischen Bauelemente (17, 18) auf unter der Bestückungsebene (Layer A) liegenden Ebenen (Layers B, C, D) angeordnet sind.

2. Hörhilfegerät nach Anspruch 1, wobei die Leiterplatte aus wenigstens einer Trägerschicht (12, 13, 14) mit wenigstens einer Bestückungsebene (Layer A) und einer Unterebene (Layer D) besteht, wobei die Bestückungsebene oder Bestückungsebenen (Layer A/D) bis auf ihre Kontaktanschlüsse (15, 15', 15'', 15''') oder Kontakt- und Leiterflächen zur Kontaktierung elektrischer Bauelemente (17, 18) sowie die Unterseite der Unterebene (Layer D) der Leiterplatte (10) mit Massepotential belegt sind.

3. Hörhilfegerät nach den Ansprüchen 1 und 2, wobei an der Unterseite der Leiterplatten-Unterebene (Layer D) Testanschlüsse (21, 22) vorgesehen sind.
